(19) Europäisches Patentamt
European Patent Office
Office européen des brevets

(11) **EP 1 830 474 B1**

(12) **FASCICULE DE BREVET EUROPEEN**

(45) Date de publication et mention de la délivrance du brevet:
**20.01.2010 Bulletin 2010/03**

(51) Int Cl.:
*H04B 1/69* (2006.01)     *G01S 7/292* (2006.01)
*G01S 13/02* (2006.01)    *G01S 13/16* (2006.01)
*H03D 11/00* (2006.01)

(21) Numéro de dépôt: **07290254.7**

(22) Date de dépôt: **28.02.2007**

(54) **Dispositif et procédé de réception ultra-large bande utilisant un détecteur à super-régénération**

Ultrabreitbandiges Empfangs-Verfahren und -Vorrichtung mit superregenerativem Detektor

Apparatus and method of ultra wide band reception with a superregenerative detector

(84) Etats contractants désignés:
**AT BE BG CH CY CZ DE DK EE ES FI FR GB GR HU IE IS IT LI LT LU LV MC NL PL PT RO SE SI SK TR**

(30) Priorité: **03.03.2006 FR 0601945**

(43) Date de publication de la demande:
**05.09.2007 Bulletin 2007/36**

(73) Titulaire: **Commissariat à l'Energie Atomique 75015 Paris (FR)**

(72) Inventeurs:
• **Pelissier, Michaël 38000 Grenoble (FR)**

• **Morche, Dominique 38240 Meylan (FR)**

(74) Mandataire: **Rosenberg, Muriel Sylvie Santarelli, 14 avenue de la Grande Armée, B.P. 237 75822 Paris Cedex 17 (FR)**

(56) Documents cités:
**EP-A- 1 655 853     WO-A-03/009482
US-A- 3 329 952     US-A- 4 393 514
US-A- 4 749 964**

## Description

La présente invention se rapporte à un dispositif et à un procédé de réception ultra-large bande utilisant un détecteur à super-régénération. Plus particulièrement, la présente invention concerne un récepteur d'ondes radiofréquence (le terme radiofréquence est désigné dans toute la suite par "RF") mettant en oeuvre la technologie ULB (Ultra-Large Bande, en anglais *"UWB, Ultra Wide Band"*) et un procédé de réception correspondant.

L'invention peut être avantageusement utilisée dans des applications basse consommation.

L'invention appartient au domaine des communications ULB en mode impulsionnel. La technique de communication ULB en mode impulsionnel consiste à transmettre des impulsions de courte durée (de l'ordre de la nanoseconde). Les signaux impulsionnels considérés ont une bande passante de plusieurs gigahertz.

L'information peut être codée via le niveau ou l'amplitude de ces impulsions (par exemple, modulation d'impulsions en amplitude, en anglais PAM, *"Pulse Amplitude Modulation"*) et/ou via la position dans le temps de ces impulsions (en anglais PPM, *"Pulse Position Modulation"*).

Un signal v(t) du type de ceux considérés dans le cadre de la technique de communication ULB en mode impulsionnel peut généralement être exprimé dans le domaine temporel comme le produit d'une portion de sinusoïde de fréquence centrale $f_c$ par une fenêtre temporelle w(t), soit, sous forme analytique :

$$v(t) = \sin(2\pi f_c \times t) \times w(t)$$

Le fenêtrage temporel commande la forme du spectre et on peut utiliser pour fenêtre w(t) une porte rectangulaire, triangulaire ou gaussienne. Dans ce dernier cas :

$$w(t) = \exp\left[-\left(\frac{t}{\tau}\right)^2\right]$$

où $\tau$ caractérise la longueur temporelle de l'impulsion.

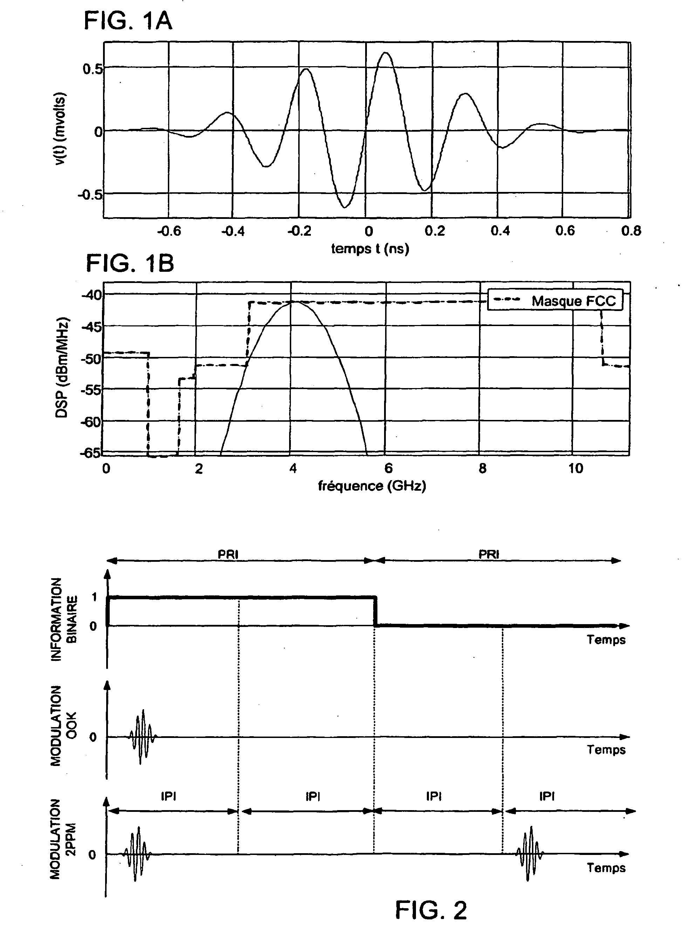

Typiquement, la fréquence centrale $f_c$ est prise égale à 4,1 GHz et la largeur de l'impulsion $\tau$ vaut 342 ps, ce qui correspond à une occupation spectrale de 2 GHz à -10 dB. Les graphiques des **figures 1A** et **1B** donnent respectivement l'allure temporelle et l'allure fréquentielle d'un tel signal.

Sur la figure 1A, le temps t en (nanosecondes) est porté en abscisse et la courbe représente le niveau du signal v(t) en volts. Sur la figure 1B, la fréquence (en GHz) est portée en abscisse et la densité spectrale de puissance (DSP) (en dBm/MHz) est portée en ordonnée. Le signal est émis avec un masque d'émission fréquentiel tel qu'autorisé par la FCC *("Federal Communications Commission").* Le signal est représenté en traits continus et le masque FCC est représenté en pointillés.

Pour transmettre l'information, comme évoqué plus haut, on peut utiliser plusieurs types de modulations, notamment par niveau ou par position dans le temps. On peut par exemple utiliser une modulation par niveau du type de la modulation tout ou rien (en anglais OOK, *"On-Off Keying";* dans la suite de la description, pour simplifier, on utilisera l'expression "modulation OOK") ou une modulation par position dans le temps du type de la modulation d'impulsions par position dans le temps à N positions (en anglais N-PPM, "*N-Pulse Position Modulation",* N représentant le nombre de positions nominales ; dans la suite de la description, pour simplifier, on utilisera les expressions "modulation PPM" et "modulation N-PPM").

Les trois chronogrammes de la **figure 2** donnent une représentation temporelle schématique de ces deux types de modulations.

Dans la modulation OOK (voir chronogramme du milieu sur le dessin), on envoie une impulsion lorsque le niveau logique vaut 1 et rien lorsqu'il vaut 0. La période de répétition des impulsions ("PRI" sur le dessin) correspond ici au rythme binaire. Cette période peut être découpée en deux intervalles de position des impulsions ("IPI" sur le dessin).

Dans la modulation PPM (voir chronogramme du bas sur le dessin : le cas de la modulation 2-PPM est illustré à titre d'exemple nullement limitatif), si l'information vaut 1, on envoie l'impulsion dans le premier intervalle et si l'information vaut 0, on envoie i'impuision dans ie deuxième intervalle.

Le secteur des télécommunications fondé sur l'ultra-large bande a suscité ces dernières années un regain d'intérêt. Des solutions ont été proposées pour assurer notamment les communications à haut débit, mais ces architectures ne permettent pas de répondre aux nouvelles attentes du domaine en termes de basse consommation et bas coût.

On connaît par le document de brevet WO-A-01 76086 une solution du type "récepteur à doigt" (en anglais "*rake receiver*")*.* Le récepteur décrit dans ce document effectue une corrélation à l'aide d'un mélangeur analogique entre le signal reçu et un motif d'impulsion élémentaire engendré au niveau du récepteur. Cette solution se concentre sur un nombre fini de trajets collectés. Chaque doigt ou trajet sur lequel le récepteur se concentre requiert un mélangeur actif augmentant la complexité et la consommation du dispositif.

Une autre solution consiste à échantillonner le signal ULB et à effectuer une corrélation avec un motif de référence numérique, afin de démoduler le signal. Ce motif de corrélation tient compte, contrairement au cas précédent, de la réponse impulsionnelle complète du canal. Néanmoins, cette solution est relativement complexe à mettre en oeuvre : du fait de la bande passante et de la fréquence centrale élevées, un échantillonnage rapide est requis afin de respecter le critère de Nyquist, nécessitant une synthèse de fréquence élevée et entraînant un flot de données numériques important. Toutes ces opérations coûteuses en énergie se font au détriment de la consommation globale du récepteur.

Des solutions émergent pour réduire la complexité de l'architecture de réception, mais elles présentent encore des inconvénients majeurs :

Une première de ces solutions est fondée sur la détection de pics d'impulsions. La mise en oeuvre de cette solution peut être obtenue par deux techniques.

La première technique correspond à un détecteur à seuil du type comparateur. Cette solution nécessite une amplification importante des signaux reçus, car la sensibilité de tels détecteurs est généralement relativement faible. La consommation est alors commandée par les étages de gain.

On connaît par le document de brevet US-A-5 901 172 une seconde technique, qui correspond à l'utilisation d'une diode à effet tunnel : on polarise la diode à la tension pic au voisinage de la zone d'instabilité à pente négative. Lorsque le niveau du signal est suffisant, il fait déclencher l'effet tunnel de la diode et le point de fonctionnement bascule dans la zone "vallée" de la caractéristique de la diode, permettant ainsi de détecter la présence d'une impulsion. Un inconvénient de cette solution est la dérive du point de polarisation de la diode en fonction de la température et des fluctuations de l'alimentation, ce qui dégrade la sensibilité du récepteur. Des solutions existent pour tenter de remédier à cet inconvénient, par exemple en positionnant des atténuateurs de signaux pour ajuster le point de polarisation, mais ces solutions de compensation ne sont guère efficaces en termes de consommation énergétique.

Une autre solution consiste à travailler avec des architectures à détection d'énergie. Ces architectures agglomèrent l'ensemble de l'énergie récupérée dans le canal de propagation. Cette opération nécessite le redressement du signal ULB avant d'intégrer le résultat sur une fenêtre d'intégration correspondant à l'étalement du canal. Toutefois, les très faibles niveaux de signaux reçus (de l'ordre de grandeur de quelques dizaines de microvolts) ne permettent généralement pas d'effectuer cette opération sans procéder au préalable à une amplification significative. Cette amplification requiert une consommation importante, ce qui limite l'intérêt d'une telle solution. En outre, le fait d'agglomérer toute l'énergie ne permet pas de tirer bénéfice de l'excellente résolution temporelle offerte par l'ULB.

Ainsi, l'art antérieur précité ne permet pas de répondre au besoin d'une architecture et d'un processus de réception de signaux ultra-large bande dont la mise en oeuvre soit simple et qui permettent de développer des récepteurs ayant une faible consommation et qui puissent assurer des besoins de localisation et de communication.

Par ailleurs, l'architecture de réception RF à base de dispositifs dits à super-régénération a été présentée pour la première fois en 1922 par E. H. AMSTRONG dans un article intitulé "Some recent developments of regenerative circuits", in Proc. IRE, vol. 10, août 1922, pages 244 à 260. Le principe du super-régénérateur est le suivant : au coeur du dispositif, on trouve un oscillateur placé en limite d'instabilité. Lorsque le signal arrive, l'énergie apportée déclenche ce dernier, qui part en oscillation. Lorsqu'il y a uniquement du bruit à l'entrée du dispositif, le démarrage s'effectue beaucoup plus lentement, permettant ainsi de différencier le cas où un signal est présent du cas où il n'y a que du bruit. La théorie générale d'utilisation de ce dispositif pour la réception de signaux RF est présentée dans un ouvrage spécialisé de J.R. WHITEHEAD intitulé "Super-Regenerative Receivers" paru aux éditions Cambridge University Press en 1950.

Cette architecture présente l'avantage de fournir une amplification quasiment infinie pour une consommation réduite. Elle a trouvé des applications dans les années 50 dans le domaine du radar impulsionnel dans lequel le niveau des signaux à traiter en réflexion était très faible. On pourra se reporter à ce sujet au document de brevet US-A-3 329 952 déposé en 1957 et délivré en 1967.

Les choix de mise en oeuvre de l'époque rendent cependant difficile à l'heure actuelle la réalisation de tels dispositifs en technologie microélectronique intégrée à faible tension.

En outre, dans les applications considérées à l'époque, la propagation des signaux s'effectuait en espace libre, alors que les environnements actuellement envisagés dans les applications ULB sont bien différents et très variés et nécessitent une adaptation particulière de l'architecture de réception ainsi que du processus de réception correspondant.

Le super-régénérateur a été employé ces dernières années pour démoduler un signal, non pas ultra-large bande, mais à bande étroite, avec ou sans technique d'étalement de spectre. On pourra se reporter à ce sujet au document de brevet WO-A-03 009482. Un avantage de cette solution réside dans son faible coût de mise en oeuvre et sa faible consommation, justifiant son utilisation dans des applications du type des télécommandes, par exemple. Dans cette solution, ia démodulation se fait par conversion directe du signal RF en bande de base. La tendance actuelle dans les applications à bande étroite est d'utiliser des résonateurs à grand facteur de qualité du type résonateur à onde acoustique de surface (en anglais SAW, *"Surface Acoustic Wave")* afin d'améliorer la sélectivité de l'architecture à super-régénération. Un tel dispositif est décrit dans le document de brevet US-A-4 749 964.

Malgré tout, appliqué aux communications à bande étroite, le super-régénérateur présente un inconvénient significatif, à savoir, une bande passante trop large vis-à-vis de la bande du signal modulé. Cela rend la communication vulnérable car sensible à des perturbateurs voisins ainsi qu'au bruit accumulé dans la bande.

C'est pour cette raison que des architectures hétérodynes ou homodynes à base de transposition de fréquence ont été préférées lorsque la contrainte majeure n'était pas la consommation.

En revanche, dans le contexte ULB, l'inconvénient précité peut s'avérer au contraire être un avantage intéressant, dans la mesure où la bande du signal occupe, comme rappelé en introduction, plusieurs GHz. Un récepteur à grande bande passante est donc requis pour obtenir de bonnes performances en détection.

En outre, du fait du fonctionnement du super-régénérateur en soi, le circuit ne récupère pas toute l'énergie qu'on envoie sur une porteuse sinusoïdale, par exemple ; il est sensible à une portion seulement de cette énergie, correspondant à la phase dans laquelle l'oscillateur est en limite d'instabilité. Le super-régénérateur échantillonne donc naturellement le signal d'entrée. Cette propriété est particulièrement bien adaptée aux signaux ULB dans la mesure où l'énergie se retrouve concentrée sur la période de temps où l'impulsion ULB est émise. Enfin, en bande étroite, à la différence de l'ULB, un écart sur l'accord entre la fréquence de résonance du super-régénérateur et la fréquence porteuse du signal conduit à une dégradation de la sensibilité du dispositif. Des contraintes de réalisation apparaissent de ce fait sur les dispositifs à bande étroite, qu'on ne retrouve pas lorsqu'un spectre étalé est utilisé pour l'excitation.

Ainsi, contrairement aux idées reçues, malgré la sélectivité en fréquence du dispositif oscillant d'un super-régénérateur, ce dernier est, à puissance moyenne constante, plus efficace sur un système ULB que sur un système à bande étroite.

La présente invention a pour but de remédier aux inconvénients de l'art antérieur.

En particulier, la présente invention vise à associer l'architecture à super-régénération à la démodulation de signaux ultra-large bande et vise à utiliser cette même architecture pour assurer notamment la localisation entre deux moyens de communication, par exemple un récepteur et un émetteur.

Dans ce but, la présente invention propose un dispositif de réception de signaux radiofréquence ULB (Ultra-Large Bande) impulsionnels comportant des moyens d'amplification, des moyens d'oscillation répondant à une commande d'instabilité, des moyens de mise en forme, des moyens de démodulation, ce dispositif de réception étant remarquable en ce qu'il comporte en outre des moyens de commande d'adaptation au type de signaux à recevoir.

Ainsi, le récepteur ultra-large bande conforme à l'invention présente une faible consommation d'énergie et une faible complexité de réalisation, tout en présentant une très grande bande passante.

Dans un mode particulier de réalisation, les moyens de commande d'adaptation du dispositif de réception au type de signaux à recevoir comportent des moyens d'optimisation du contrôle de la commande d'instabilité des moyens d'oscillation.

L'adéquation entre la commande d'instabilité du récepteur et le type de signaux à détecter permet d'optimiser la bande passante du récepteur en fonction du signal afin de maximiser le rapport entre le niveau du signal utile et le bruit.

Dans ce mode particulier de réalisation, selon une caractéristique particulière, les moyens de commande d'adaptation mettent en oeuvre une forme prédéterminée de commande d'amortissement pour fournir une expression analytique du type de signaux reçus.

Dans un mode particulier de réalisation avec un environnement dit multitrajets, c'est-à-dire où les signaux sont reçus en provenance de trajets multiples, le dispositif de réception peut comporter des moyens de pondération de chacun de ces trajets.

Dans un tel mode de réalisation, selon une caractéristique particulière, le dispositif de réception peut comporter en outre des moyens de retard pour appliquer à chacun des trajets un retard prédéterminé.

Selon une caractéristique particulière, la commande d'amortissement est différente pour chacun des trajets.

Selon une caractéristique particulière, les signaux peuvent être modulés suivant une modulation par tout ou rien (OOK, *"On-Off Keying").*

En variante, les signaux peuvent être modulés suivant une modulation d'impulsions par position dans le temps à N positions, où N est un entier prédéterminé (N-PPM, *"N-Pulse Position Modulation").*

Le dispositif de réception conforme à la présente invention trouve un grand nombre d'utilisations particulièrement avantageuses.

Par exemple, il peut être utilisé à des fins de communication, comme dispositif de réception en tant que tel ou comme partie d'un dispositif d'émission/réception. Un tel dispositif peut être inclus, à titre d'exemple non limitatif, dans un appareil radioélectrique, dans le cadre de la communication avec un ou plusieurs dispositifs d'émission ou d'émission/réception appropriés, par exemple contenus en tout ou partie dans un ou plusieurs appareils radioélectriques.

Ainsi, la présente invention propose aussi un moyen de communication, comportant des moyens d'oscillation répondant à une commande d'instabilité, ce moyen de communication étant remarquable en ce qu'il comporte en outre des moyens de commande d'adaptation d'un dispositif de réception tel que ci-dessus au type de signaux à recevoir.

La présente invention propose en outre un appareil d'émission/réception, comportant des moyens d'oscillation répondant à une commande d'instabilité, cet appareil d'émission/réception étant remarquable en ce qu'il comporte en outre des moyens de commande d'adaptation d'un dispositif de réception tel que ci-dessus au type de signaux à recevoir.

La présente invention propose aussi un appareil d'émission/réception, remarquable en ce qu'il comporte un dispositif de réception tel que ci-dessus.

Ce récepteur est en outre capable d'atteindre une très grande résolution temporelle, tirant ainsi profit de la nature des signaux ULB, en vue d'adjoindre la fonctionnalité de localisation au récepteur.

Il peut ainsi être utilisé de façon également avantageuse pour la localisation d'un ou plusieurs appareils radioélectriques, notamment par un ou plusieurs autres appareils radioélectriques, la fonction de localisation pouvant être associée ou non à la fonction de communication, selon les besoins de l'application considérée.

Ainsi, la présente invention propose également un dispositif de localisation d'un moyen de communication par un autre moyen de communication, ces moyens de communication comportant des moyens de mesure du temps, des moyens de conversion tension-temps et des moyens d'oscillation répondant à une commande d'instabilité, ce dispositif de localisation étant remarquable en ce qu'il comporte en outre des moyens de commande d'adaptation d'un dispositif de réception tel que ci-dessus au type de signaux à recevoir.

La présente invention propose aussi un dispositif de localisation d'un moyen de communication par un autre moyen de communication, ces moyens de communication comportant des moyens de mesure du temps, des moyens de conversion tension-temps et des moyens d'oscillation répondant à une commande d'instabilité, ce dispositif de localisation étant remarquable en ce qu'il comporte un dispositif de réception tel que ci-dessus.

Dans un mode particulier de réalisation, le dispositif de localisation comporte des moyens d'estimation de distance par calcul du temps de vol aller-retour.

Cela permet d'obtenir une bonne résolution temporelle et donc, de tirer parti de ia nature même des signaux à traiter.

Par ailleurs, toujours dans l'optique de minimiser la consommation d'énergie électrique, le dispositif de réception conforme à la présente invention peut aussi être avantageusement utilisé pour automatiquement mettre ou remettre en route, ou en état d'éveil, un appareil radioélectrique qui se trouvait en état de veille. Cela permet en effet de réduire en particulier la consommation en état de veille du récepteur.

Ainsi, la présente invention propose un dispositif de mise en état d'éveil d'un appareil radioélectrique, comportant des moyens d'oscillation répondant à une commande d'instabilité, ce dispositif de mise en état d'éveil étant remarquable en ce qu'il comporte en outre des moyens de commande d'adaptation d'un dispositif de réception tel que ci-dessus au type de signaux à recevoir.

La présente invention propose un dispositif de mise en état d'éveil d'un appareil radioélectrique, remarquable en ce qu'il comporte un dispositif de réception tel que ci-dessus.

De même qu'elle propose un dispositif de réception, la présente invention propose également un procédé de réception de signaux radiofréquence ULB (Ultra-Large Bande) impulsionnels, comportant une étape d'amplification, une étape d'oscillation conditionnée par une étape de commande d'instabilité, une étape de mise en forme, une étape de démodulation, ce procédé étant remarquable en ce que l'étape d'oscillation est en outre effectuée en fonction d'une étape de commande d'adaptation du procédé de réception au type de signaux à recevoir.

Les caractéristiques particulières et les avantages de ce procédé sont similaires à ceux détaillés plus haut en regard du dispositif de réception et ne sont donc pas répétés ici.

L'invention propose de même un procédé de mise en état d'éveil d'un appareil radioélectrique comportant une étape d'oscillation conditionnée par une étape de commande d'instabilité, ce procédé de mise en état d'éveil étant remarquable en ce qu'il comporte en outre une étape de commande d'adaptation d'un procédé de réception tel que ci-dessus au type de signaux à recevoir.

L'invention propose aussi un procédé de mise en état d'éveil d'un appareil radioélectrique, remarquable en ce qu'il comporte des étapes d'un procédé de réception tel que ci-dessus.

L'invention propose aussi un procédé de localisation d'un moyen de communication par un autre moyen de communication, ces moyens de communication comportant des moyens de mesure du temps, des moyens de conversion tension-temps et des moyens d'oscillation répondant à une commande d'instabilité, ce procédé de localisation étant remarquable en ce qu'il comporte en outre une étape de commande d'adaptation d'un procédé de réception tel que ci-dessus au type de signaux à recevoir.

L'invention propose aussi un procédé de localisation d'un moyen de communication par un autre moyen de communication, ces moyens de communication comportant des moyens de mesure du temps, des moyens de conversion tension-temps et des moyens d'oscillation répondant à une commande d'instabilité, ce procédé de localisation étant remarquable en ce qu'il comporte des étapes d'un procédé de réception tel que ci-dessus.

L'invention propose aussi un procédé d'émission/réception comportant une étape d'oscillation conditionnée par une étape de commande d'instabilité, ce procédé d'émission/réception étant remarquable en ce qu'il comporte en outre une étape de commande d'adaptation d'un procédé de réception tel que ci-dessus au type de signaux à recevoir.

L'invention propose aussi un procédé d'émission/réception, remarquable en ce qu'il comporte des étapes d'un procédé de réception tel que ci-dessus.

L'invention propose aussi un procédé de traitement de signaux, remarquable en ce qu'il met en oeuvre des étapes d'un procédé de réception tel que ci-dessus.

L'invention propose aussi un appareil de traitement de signaux, remarquable en ce qu'il comporte un dispositif de réception et/ou un dispositif de localisation tels que ci-dessus.

L'invention propose aussi un appareil nomade, remarquable en ce qu'il comporte un dispositif de réception et/ou un dispositif de localisation tels que ci-dessus.

L'invention propose aussi un téléphone mobile, remarquable en ce qu'il comporte un dispositif de réception et/ou un dispositif de localisation tels que ci-dessus.

L'invention propose aussi un appareil multimédia, remarquable en ce qu'il comporte un dispositif de réception et/ou un dispositif de localisation tels que ci-dessus.

Ces procédés et appareils présentent des caractéristiques particulières et des avantages similaires à ceux déjà mentionnés pour le dispositif de réception.

D'autres aspects et avantages de l'invention apparaîtront à la lecture de la description détaillée qui suit de modes particuliers de réalisation, donnés à titre d'exemples non limitatifs. La description se réfère aux dessins qui l'accompagnent, dans lesquels :

- les figures 1A et 1B, déjà décrites, représentent, respectivement dans le domaine temporel et dans le domaine fréquentiel, l'allure d'un signal du type de ceux considérés dans le cadre de la présente invention, dans un mode particulier de réalisation ;
- la figure 2, déjà décrite, illustre de façon schématique deux types de modulations couramment utilisées dans le domaine des communications ULB;
- la figure 3 représente de façon schématique l'architecture générale d'un démodulateur ULB utilisant un super-régénérateur, du type de celui mis en oeuvre par la présente invention, dans un mode particulier de réalisation ;
- la figure 4 représente de façon schématique un oscillateur du type de celui mis en oeuvre par la présente invention, dans un mode particulier de réalisation ;
- la figure 5 illustre des chronogrammes de signaux mis en jeu autour d'un oscillateur tel que celui de la figure 4, dans un mode particulier de réalisation ;
- la figure 6 illustre de façon schématique un étage de mise en forme du type de celui mis en oeuvre par ia présente invention, dans un mode particulier de réalisation ;
- les figures 7A et 7B représentent de façon schématique un bloc de démodulation du type de celui mis en oeuvre par la présente invention, respectivement dans deux modes particuliers de réalisation ;
- la figure 8 représente de façon schématique l'architecture générale d'un démodulateur ULB utilisant un super-régénérateur, du type de celui mis en oeuvre par la présente invention, dans un mode particulier de réalisation pour un environnement avec des canaux de propagation multitrajets ;
- la figure 9 illustre des chronogrammes de la réponse d'un super-régénérateur optimisé tel que celui de la figure 8, dans un mode particulier de réalisation ;
- la figure 10 illustre, dans un mode particulier de réalisation de la présente invention, des chronogrammes de la réponse d'un super-régénérateur optimisé tel que celui de la figure 8, où un filtrage adapté au signal reçu est en outre effectué ;
- la figure 11 illustre des chronogrammes d'estimation de distance par la technique, connue en soi, de calcul du temps de vol aller-retour, dans un mode particulier de réalisation de la présente invention où celle-ci est utilisée comme dispositif de localisation ; et
- la figure 12 est un organigramme illustrant les principales étapes d'un procédé de réception conforme à la présente invention, dans un mode particulier de réalisation.

Comme indiqué plus haut, partant en particulier du constat que les récepteurs ULB actuels ne permettent pas d'avoir une consommation électrique très faible et que les signaux envoyés sur une porteuse sinusoïdale ne permettent pas d'exploiter pleinement les capacités des architectures à super-régénération, l'invention utilise un super-régénérateur pour la réception et la démodulation de signaux ultra-large bande.

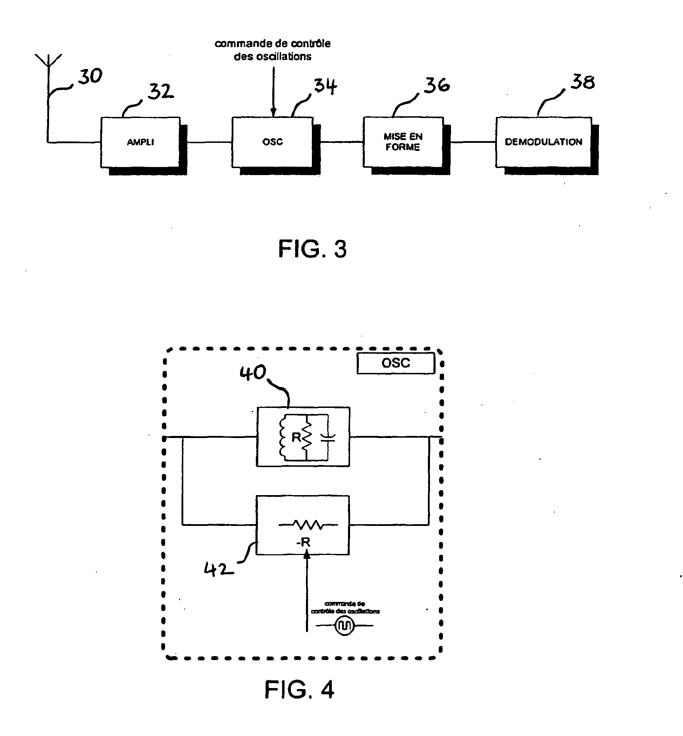

Le schéma-bloc de la figure 3 présente l'architecture générale d'un dispositif de réception avec démodulateur ULB à base de super-régénérateur, conforme à la présente invention, dans un mode particulier de réalisation.

Ce dispositif de réception à super-régénération comprend un oscillateur 34 dont on contrôle les phases d'instabilité et d'amortissement par l'intermédiaire d'une commande périodique : le signal d'amortissement. Ce signal de commande, qui peut venir de l'extérieur ou être engendré en fonction de la sortie du récepteur, permet d'optimiser la sensibilité du récepteur par rapport au signal à détecter. Conformément à la présente invention, on cherche en outre à optimiser le signal de commande vis-à-vis du signal ULB à détecter. Plus particulièrement, la fonction de sensibilité du récepteur peut être adaptée à l'impulsion ULB reçue, puisqu'elle présente la même forme gaussienne. Lorsque l'oscillateur est placé en limite d'instabilité et qu'il reçoit l'apport d'énergie d'une impulsion ULB, les oscillations s'amorcent et divergent jusqu'à ce que la commande d'amortissement vienne les éteindre.

A la sortie de l'oscillateur 34, on trouve un étage 36 de mise en forme du signal. Cet étage effectue principalement une conversion en bande de base du signal oscillant à la fréquence centrale de l'oscillateur.

Derrière l'étage 36 de mise en forme, on trouve un bloc 38 de démodulation permettant d'extraire l'information. En effet, lorsqu'il n'y a pas de signal (cas qu'on peut par exemple associer au niveau logique "0" dans le cas d'une modulation OOK), l'oscillateur démarre moins rapidement, puisqu'il reçoit moins d'énergie. Le démodulateur assure la prise de décision entre le cas où il y a du signal (niveau logique "1") et le cas où il n'y a que du bruit (niveau logique "0").

Enfin, on trouve en amont de l'oscillateur 34 une antenne 30 qui assure la conversion de l'énergie électromagnétique rayonnée en énergie électrique utilisable dans le circuit de réception. Un amplificateur 32 permet de limiter le niveau de bruit global de la chaîne de réception et d'isoler le signal oscillant de l'antenne 30 pour éviter tout rayonnement du récepteur. La bande passante de l'amplificateur 32 est importante mais son gain peut être limité, dans la mesure où l'amplificateur est suivi par le super-régénérateur, fournissant lui aussi du gain.

L'oscillateur utilisé au coeur du super-régénérateur est un système actif travaillant à une seule fréquence : sa fréquence propre d'oscillation. De ce fait, l'oscillateur est d'autant plus sensible à un signal excitateur qu'il est excité par un signal battant à la même fréquence. C'est ce principe de base qui a permis l'utilisation massive du super-régénérateur dans les applications à bande étroite, pour lesquelles l'énergie du signal excitateur se concentre autour d'une fréquence porteuse correspondant à la fréquence propre d'oscillation. Un aspect particulièrement avantageux de l'invention consiste à proposer une optimisation du système de façon que, malgré la sélectivité en fréquence naturelle de l'oscillateur, le super-régénérateur détecte un signal impulsionnel occupant un spectre de fréquence très large.

Dans les dispositifs de réception ULB, les deux blocs les plus critiques en termes de consommation sont la chaîne d'amplification et la synthèse de fréquence.

En effet, typiquement, les signaux ULB occupent plus de 2 GHz de bande. Pour amplifier de tels signaux de façon significative, il est nécessaire d'utiliser un amplificateur avec un produit gain bande élevé, entraînant une consommation importante d'énergie par l'étage correspondant. Dans l'architecture de réception conforme à la présente invention, le gain est quasiment infini sans engendrer pour autant une consommation plus importante, puisque ce gain est fourni par un dispositif instable. En outre, la bande passante du dispositif est une bande passante effective instantanée contrôlée par un signal de commande. Le super-régénérateur présente ainsi une large bande uniquement aux instants de décision, permettant ainsi de diminuer la consommation.

Un signal ULB typique considéré dans le cadre de la présente invention étudié est centré autour d'environ 4 GHz. Pour restituer la forme du signal, il est nécessaire, dans les solutions traditionnelles, d'effectuer une conversion en bande de base en utilisant un mélangeur, un oscillateur ou un signal de référence travaillant à de telles fréquences. Une autre solution de l'art antérieur consiste à faire de l'échantillonnage direct à une fréquence supérieure à environ 10GHz. Ces solutions sont particulièrement consommatrices d'énergie au niveau de la synthèse de fréquence. Le super-régénérateur permet d'éviter cet écueil, puisqu'il effectue un échantillonnage au rythme de l'information, à savoir, de l'ordre de quelques dizaines de kilohertz, relâchant ainsi nettement les contraintes.

Enfin, d'autres solutions précitées (de détection d'énergie) de l'art antérieur effectuent un échantillonnage au rythme de l'information pour limiter la consommation due à la synthèse de fréquence. Cependant, ces solutions, en agglomérant l'énergie contenue dans le canal de transmission, font disparaître un des avantages majeurs de l'ULB : une excellente résolution temporelle intrinsèque. Ainsi, ces solutions ne permettent pas de bénéficier de la précision requise pour assurer la fonctionnalité de localisation. Au contraire, le super-régénérateur, lorsque la fonction de sensibilité est optimisée, effectue une détection au niveau de l'impulsion, permettant ainsi d'atteindre des résolutions de l'ordre de grandeur de la nanoseconde.

Dans un mode particulier de réalisation de la présente invention, on optimise l'architecture de réception afin de détecter une impulsion ULB et de démoduler le signal. L'oscillateur présenté sur la **figure 4** est composé d'un résonateur passif 40, du type cellule LC, dont on règle la fréquence de résonance propre à la fréquence centrale du signal d'excitation ULB. Compte tenu du spectre étalé du signal, l'accord entre ces deux fréquences est beaucoup moins déterminant que dans les applications à bande étroite. Pour compenser les pertes de ce résonateur, on ajoute, en parallèle, un élément actif 42 qui engendre une résistance négative, assurant le contrôle du facteur d'amortissement de l'oscillateur ainsi créé.

Sans commande extérieure, le facteur d'amortissement de la cavité du résonateur est lié aux pertes du résonateur et vaut $\varsigma_0$. Lorsqu'on applique un signal de commande, ce facteur varie. Lorsque le facteur d'amortissement $\varsigma$ s'annule, l'oscillateur devient instable : c'est alors que le dispositif est sensible au signal d'entrée. Il échantillonne ainsi le signal ULB et part en oscillation. La forme du signal de commande d'amortissement permet d'ajuster la bande passante du récepteur en fonction de la bande passante du signal d'entrée, de contrôler le gain de régénération, de commander la forme du signal de sortie et d'ajuster la rapidité d'extinction des oscillations. Conformément à la présente invention, on cherche à optimiser ce signal de commande en fonction des caractéristiques du signal ULB pour maximiser la capacité de détection des impulsions du circuit. La fonction de sensibilité du récepteur, notée s(t), peut être exprimée à l'instant t0 d'échantillonnage du signal d'entrée, c'est-à-dire à l'instant où le facteur d'amortissement s'annule par front descendant (on pourra se reporter à ce sujet à l'ouvrage de J.R. WHITEHEAD cité plus haut) :

$$s(t) = \exp-\left[\frac{t-t0}{\tau_s}\right]^2 \text{ avec } \tau_s = \sqrt{\frac{2}{-\varsigma'(t0)}}$$

On constate que la fonction de sensibilité s(t) du récepteur est une fonction gaussienne du temps, centrée sur l'instant d'échantillonnage. La fonction de sensibilité est adaptée au signal d'entrée lorsque le paramètre $\tau_s$ de cette gaussienne est adaptée au paramètre $\tau$ de la gaussienne de l'enveloppe du signal ULB définie en introduction (voir fenêtre w(t)).

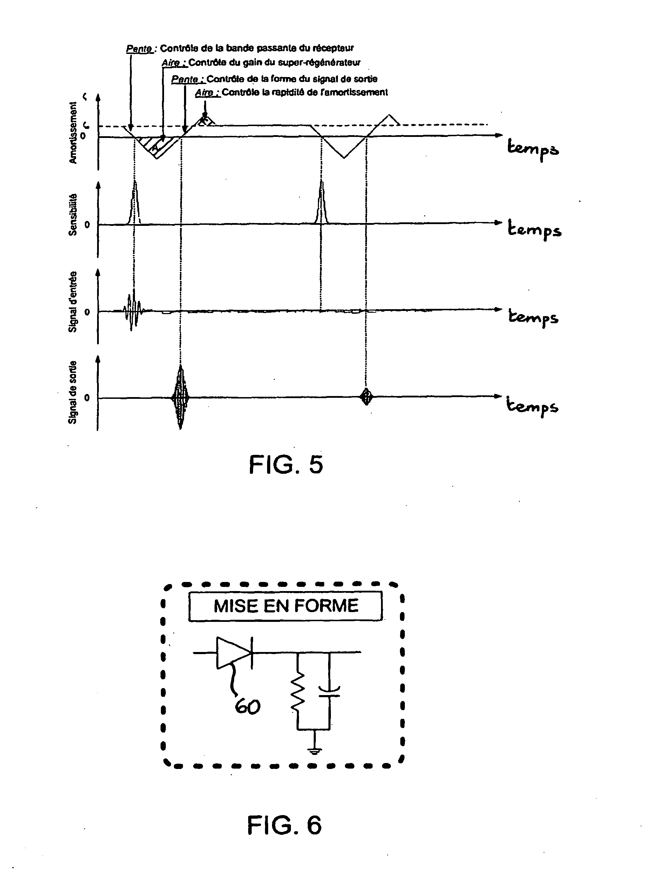

Pour augmenter la bande passante du récepteur et atteindre une valeur de $\tau_s$ valant 342 ps, il faut donc une dérivée en t0 élevée. Typiquement, on utilise un signal de commande en dent de scie ou sinusoïdal. La solution consiste donc à augmenter la fréquence ou l'amplitude du signal de commande. Or l'amplitude du signal de commande est directement liée à la consommation de la résistance négative. Afin d'envisager un récepteur à basse consommation, il est préférable de jouer sur la fréquence. Cependant, une fréquence trop élevée entraîne un échantillonnage trop rapide du signal d'entrée. Ainsi, les oscillations du précédent cycle d'échantillonnage risquent de ne pas avoir eu le temps de s'éteindre avant qu'un nouveau cycle commence et ce, en particulier dans le cas de résonateurs passifs à faibles pertes présentant un facteur de qualité élevé et donc un facteur d'amortissement faible. Les chronogrammes de la **figure 5** illustrent une réalisation possible dans ce contexte.

Comme représenté sur la figure 5, on choisit pour exemple un signal de commande triangulaire relativement répandu, qu'on optimise par rapport au signal ULB considéré. Les chronogrammes mettent en évidence deux phases d'échantillonnage, respectivement, du signal ULB et du bruit. On constate que lorsque l'impulsion est présente, le signal de sortie de l'oscillateur a une amplitude plus importante que lorsqu'il est déclenché uniquement par le bruit. L'optimisation de la commande d'amortissement passe par quatre réglages de la commande :

- la pente négative permet d'avoir une fonction de sensibilité adaptée à l'impulsion. Elle est optimisée pour avoir $\tau_s = \tau$ ;
- l'aire négative A- est liée au gain de super-régénération engendrée par l'instabilité de l'oscillateur. Elle est optimisée de façon à ce que le dispositif fournisse un gain suffisant pour que l'étage de mise en forme, derrière l'oscillateur (voir figure 3 décrite plus haut) puisse travailler avec des signaux ayant un niveau significatif (typiquement, de l'ordre de la centaine de mV) ;
- la pente positive commande la forme du signal de sortie. Dans le cas où la pente est identique, en valeur absolue, à la pente négative, on retrouve en sortie un signal de même allure qu'en entrée, amplifié par rapport au signal d'entrée ;
- l'aire positive A+ permet de forcer l'extinction des oscillations dans le cas où l'amortissement propre du résonateur ne suffit pas pour éteindre les oscillations. Ce paramètre est important lorsqu'on utilise un signal de commande relativement rapide.

L'étage de mise en forme peut être un détecteur à seuil ou un détecteur d'enveloppe. La réalisation avec un détecteur d'enveloppe est particulièrement avantageuse, puisqu'elle permet de travailler dans les deux modes de fonctionnement, linéaire et logarithmique, du super-régénérateur. Le détecteur d'enveloppe permet de convertir à bas coût le signal haute fréquence à la sortie de l'oscillateur, en signal en bande de base. La réalisation peut être faite en utilisant un redressement simple alternance (comme l'illustre la **figure 6**) ou un redressement double alternance suivi d'un étage de filtrage passe-bas, par exemple. Ce choix est rendu possible par le fait que les signaux à traiter présentent des amplitudes significatives, permettant d'exploiter la caractéristique non linéaire de la diode 60 (représentée sur la figure 6).

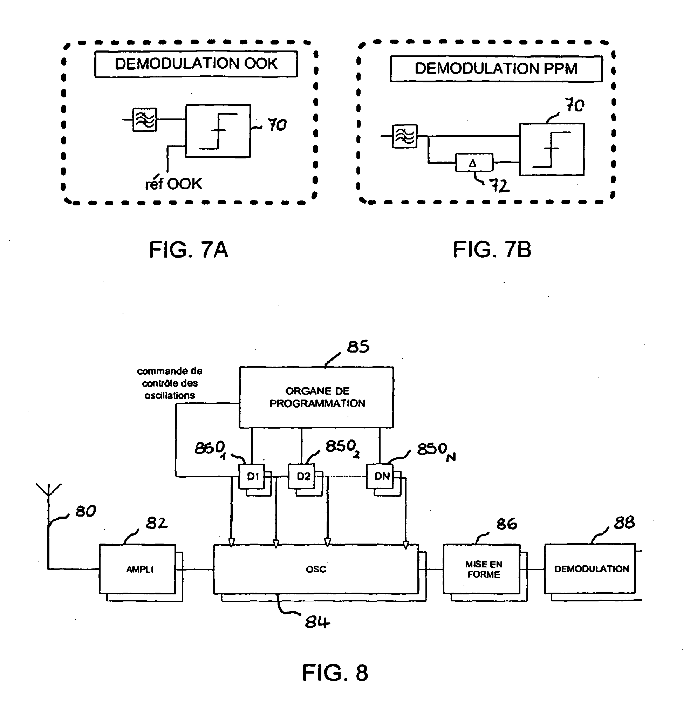

Enfin, derrière l'étage de mise en forme, on trouve le bloc de démodulation de signaux ULB. Deux réalisations peuvent être envisagées selon le type de modulation (**figures 7A et 7B**).

Dans les deux cas, on trouve un filtre intégrateur 70 qui prend la valeur moyenne du signal redressé. Dans le cas de la modulation OOK (figure 7A), on compare, de façon synchrone au rythme des symboles, cette valeur à un niveau de référence. Ce niveau de référence correspond au cas où le super-régénérateur prélève un échantillon de bruit. Le niveau de référence est estimé dans une phase d'apprentissage, dont le but est de définir ce seuil de référence, afin d'optimiser le taux de fausses alarmes et la probabilité de manquer une impulsion.

Cette phase d'apprentissage peut être coûteuse en énergie et une autre réalisation préférable est la PPM (figure 7B). Le principe du démodulateur consiste alors à comparer en permanence la valeur moyenne calculée sur un demi-temps symbole par rapport au demi-temps symbole voisin. Selon que la sortie bascule dans un sens ou dans l'autre, on peut déterminer si l'information a été transmise dans le premier intervalle temporel ou le second. Pour comparer les deux niveaux, on peut numériser la sortie de l'intégrateur. Cette solution peut être onéreuse si on veut avoir une bonne résolution dans les niveaux. La solution préférée consiste à introduire un élément retard 72 qui permet d'avoir en temps continu l'information aux rangs n et n-1. Ce retard est ajusté à la valeur d'un demi temps symbole. Le signal à son entrée étant basse fréquence, l'implémentation de ce retard ne pose pas de problème majeur. Cette modulation, contrairement au cas de la modulation OOK, permet d'avoir une estimation du niveau de bruit en temps continu.

Le mode de réalisation décrit précédemment s'applique plus particulièrement dans des environnements de propagation en visibilité directe, où le récepteur collecte le trajet direct prépondérant provenant de l'émetteur. Dans des environnements plus complexes, le récepteur reçoit non seulement le trajet direct, mais aussi une collection de trajets causée par les multiples réflexions et diffractions. On parle de trajets multiples et d'environnement multitrajets. Dans ce type d'environnement, l'énergie collectée est étalée dans le temps.

Il est possible d'utiliser la solution décrite précédemment mais dans ce cas-là, on en récupère qu'une fraction de l'énergie totale, puisqu'on se concentre sur une impulsion correspondant à un seul trajet. Le rapport signal à bruit en sortie est donc sous-optimal.

L'invention vise à proposer une amélioration du super-régénérateur monotrajet pour prendre en compte la diversité temporelle introduite par la réponse impulsionnelle du canal de transmission. Dans cet autre mode de réalisation, on envoie N commandes d'échantillonnage permettant de récolter l'énergie des N trajets majoritaires. Contrairement à des solutions du type décrit dans le document de brevet WO-A-01 76086 mentionné en introduction, qui nécessitent pour cela un récepteur plus complexe avec duplication de l'architecture, la réalisation proposée par la présente invention est aisée : la réception des N trajets s'effectue en contrôlant la fréquence d'apparition du signal de commande des amortissements.

Pour cela, on introduit une batterie de cellules retard $850_1$, $850_2$, ..., $850_N$ (D1, D2, ..., DN sur la **figure 8**) qui permet d'ajuster dans le temps les commandes d'échantillonnage sur les N instants significatifs de la réponse composite collectée. Ces retards sont contrôlés numériquement par un organe de programmation 85 qui est réinitialisé à chaque nouvelle phase d'estimation du canal. En sortie de l'oscillateur 84, les étages de mise en forme 86 et de démodulation 88 restent inchangés. On retrouve par ailleurs une antenne 80 et un étage d'amplification 82 en amont de l'oscillateur 84. Cependant, le fait d'avoir prélevé N échantillons d'énergie dans le signal permet d'augmenter la robustesse du dispositif lorsque le canal est dégradé.

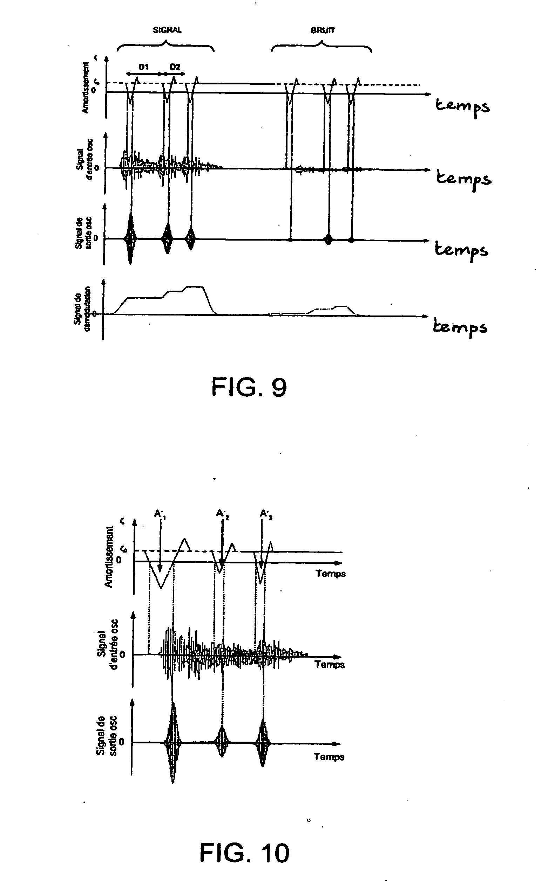

La **figure 9** donne les chronogrammes de la réponse du super-régénérateur dans le cas d'un canal de propagation dégradé. Dans l'exemple non limitatif qui est illustré, deux cellules retard sont prévues, permettant de prélever trois échantillons significatifs dans la réponse composite. Dans le cas où les échantillons sont proches les uns des autres, il est possible d'accélérer l'amortissement de la sortie de l'oscillateur en augmentant l'aire A+ définie précédemment.

Une autre solution dérivée de la précédente peut être envisagée pour optimiser les performances en démodulation. Cette variante est illustrée par les chronogrammes de la **figure 10**. On peut combiner les trajets en les pondérant différemment. Ainsi, les trajets les plus forts auront une valeur plus importante devant les plus faibles de façon à fiabiliser le processus de détection. On réalise ainsi un filtrage adapté au canal de propagation. Au niveau de l'architecture à super-régénération, cette mise en oeuvre est rendue possible en faisant varier l'aire A- qui commande le gain de super-régénération à chaque trajet que l'on veut récupérer. Une fois l'estimation de canal réalisée, la commande d'oscillation peut être engendrée pour échantillonner efficacement le signal.

Les deux nouvelles solutions de démodulation proposées utilisant un super-régénérateur, à savoir, monotrajet et multitrajets, nécessitent, avant la phase de démodulation, une phase préalable de synchronisation. Cette phase de synchronisation est indispensable à toute communication radioélectrique et est bien connue de l'homme du métier (voir par exemple le document WO-A-01 76086 précité). Elle permet de construire la forme du signal de commande d'amortissement et d'échantillonnage optimale pour la démodulation. En d'autres termes, cette phase permet de déterminer, dans le premier cas, les instants d'échantillonnage et, dans le deuxième cas, de déterminer en outre le poids à affecter à chaque échantillon. Dans cette phase de synchronisation, le récepteur scrute le canal pour déterminer à quel moment il reçoit l'impulsion. Par incrémentation successive du temps de déclenchement de la commande d'échantillonnage au fur et à mesure des répétitions de l'impulsion, le récepteur trouve l'instant optimal pour le reste de la communication. Dans la solution plus évoluée qui permet de pondérer chaque trajet, la phase de synchronisation passe par la numérisation, par un convertisseur analogique-numérique, du signal à la sortie de l'étage de mise en forme. Cette numérisation permet de stocker et de quantifier le niveau du signal reçu, de façon à attribuer un poids différent à chaque trajet de la réponse composite.

Pour consommer un minimum d'énergie, les appareils radioélectriques peuvent se mettre en état de veille. Dans un tel état, les éléments de la chaîne de réception consommateurs d'énergie sont inactifs. Pour remettre en route la partie active afin de réaliser des fonctions évoluées telles que la communication pour l'échange bidirectionnel d'information ou la localisation, un dispositif auxiliaire de mise en route est habituellement nécessaire. La solution proposée consiste à utiliser le super-régénérateur couplé à un signal d'excitation ULB pour assurer la mise en route du récepteur radioélectrique. Ce récepteur radioélectrique peut être un super-régénérateur avec des fonctions complexes, comme on vient de le présenter, ou, plus largement, un appareil radioélectrique à bande étroite. De même que dans le mode de réalisation avec détection monotrajet décrit plus haut, un seul échantillon est pris dans la réponse composite du canal.

Si cet échantillon témoigne de la présence de signal dans le canal, le récepteur complet se met en route pour assurer la communication ou d'autres fonctions. Pour minimiser les mises en route inutiles, une moyenne sur plusieurs cycles peut être effectuée pour garantir la présence effective de signal.

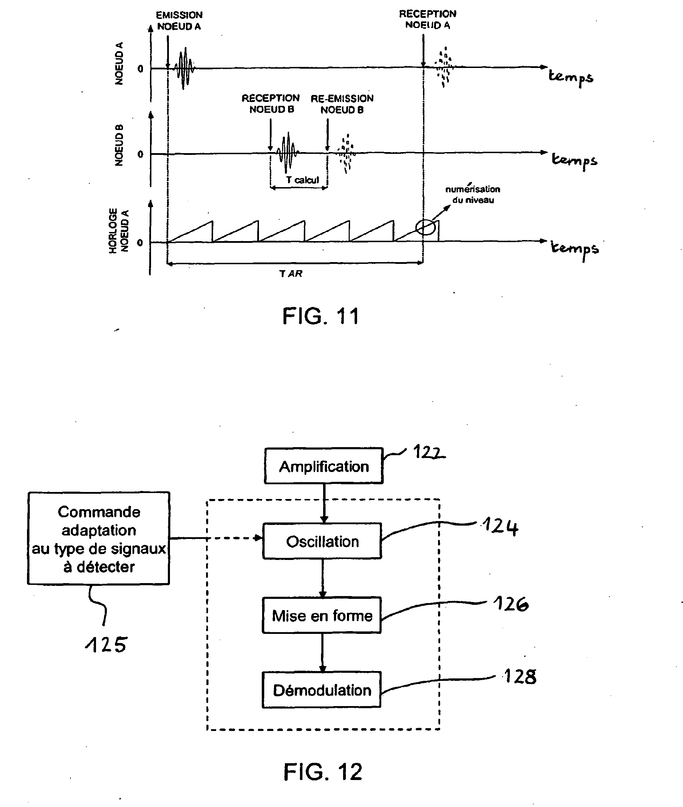

Le dispositif de réception conforme à la présente invention permet d'avoir une excellente résolution temporelle puisque sa sensibilité est ajustée à l'impulsion à détecter. Par conséquent, en utilisant la méthode, connue en soi, d'estimation du temps de vol aller-retour, ce dispositif permet de localiser un noeud d'un autre avec une grande précision. Cela est illustré par les chronogrammes de la **figure 11.** Typiquement, avec un paramètre $\tau$ de 342 ps, la largeur à la base à 99% de la gaussienne est de 623 ps, ce qui permet d'avoir une précision théorique inférieure à 19 cm. La phase d'estimation de distance nécessite un protocole d'échange particulier entre l'émetteur d'un noeud A et le récepteur d'un autre noeud B (ou vice versa), permettant de déterminer le temps de vol aller-retour entre les deux appareils. On suppose au départ que le récepteur communique avec l'émetteur en utilisant le procédé de démodulation décrit précédemment. Lorsque ce dernier entre dans la phase d'estimation de distance, le récepteur bascule dans un mode de réception spécifique. Dans ce mode, un même signal est envoyé périodiquement par l'émetteur, et le récepteur vient détecter le premier trajet de la réponse composite du canal. En effet, le premier trajet est un indicateur fidèle et non biaisé de la distance entre les deux appareils. Pour cela, la commande d'échantillonnage est avancée pas à pas à chaque nouvelle émission, de façon que le récepteur vienne sonder au fur et à mesure l'énergie contenue dans le tout début de la réponse composite. En permanence, le niveau collecté est comparé au niveau de bruit. Le processus s'arrête lorsque le récepteur a été capable de localiser le premier trajet : avant ce premier trajet, il n'y a que du bruit. Lorsque le premier trajet est localisé, on estime la distance qui sépare le noeud A du noeud B. Une méthode classique consiste à déterminer le temps mis par le signal pour faire un aller-retour. Le noeud A émet une impulsion et déclenche une base de temps. La base de temps est stoppée lorsque le premier trajet de la réponse du noeud B revient au noeud A. Connaissant la vitesse de propagation, notée c, de l'onde dans les airs, on remonte à l'information de distance, notée d, directement à partir de la mesure du temps de vol $T_{AR}$. Cette technique relativement classique est rendue possible par la précision temporelle intrinsèque du super-régénérateur. Compte tenu du fait que l'horloge du récepteur est relativement lente pour limiter la consommation, si l'impulsion de retour arrive entre deux cycles d'horloge, un dispositif de conversion tension-temps est nécessaire pour avoir une précision temporelle plus importante que la période d'horloge. Le niveau de la rampe est alors échantillonné puis numérisé et additionné au compteur de cycles d'horloge initialisé au départ de l'impulsion du noeud A. La distance d entre les noeuds A et B se calcule alors très simplement par la relation : $d = c / 2 \times (T_{AR} - T_{calcul})$.

L'organigramme de la **figure 12** reprend de façon synthétique les principales étapes d'un procédé de réception conforme à la présente invention. Etant donné que les phases successives du processus de détection ont déjà été décrites en détail plus haut, notamment en référence aux figures 3 et 8, on notera seulement ici que la figure 12 montre les étapes d'amplification 122, d'oscillation 124, de mise en forme 126 et de démodulation 128 ainsi que, selon la présente invention, la phase 125 de commande d'adaptation du processus de réception au type de signaux à détecter.

**Revendications**

1. Dispositif de réception de signaux radiofréquence ULB, Ultra-Large Bande, impulsionnels comportant des moyens (32 ; 82) d'amplification, des moyens (34 ; 84) d'oscillation répondant à une commande d'instabilité, des moyens (36 ; 86) de mise en forme, des moyens (38 ; 88) de démodulation, **caractérisé en ce qu'**il comporte en outre des moyens (85) de commande d'adaptation desdits moyens d'oscillation au type de signaux à recevoir.

2. Dispositif de réception selon la revendication 1, **caractérisé en ce que** les moyens (85) de commande d'adaptation dudit dispositif au type de signaux à recevoir comportent des moyens d'optimisation du contrôle de la commande d'instabilité des moyens (34 ; 84) d'oscillation.

3. Dispositif de réception selon la revendication précédente, **caractérisé en ce que** lesdits moyens (85) de commande d'adaptation mettent en oeuvre une forme prédéterminée de commande d'amortissement pour fournir une expression analytique du type de signaux reçus.

4. Dispositif de réception selon la revendication 1, 2 ou 3, lesdits signaux étant reçus en provenance de trajets multiples, ledit dispositif de réception étant **caractérisé en ce qu'**il comporte des moyens de pondération de chacun desdits trajets.

**5.** Dispositif de réception selon la revendication précédente, **caractérisé en ce qu'**il comporte en outre des moyens de retard pour appliquer à chacun desdits trajets un retard prédéterminé.

**6.** Dispositif de réception selon les revendications 3 et 5, **caractérisé en ce que** la commande d'amortissement est différente pour chacun desdits trajets.

**7.** Dispositif de réception selon l'une quelconque des revendications précédentes, **caractérisé en ce que** les signaux sont modulés suivant une modulation par tout ou rien, OOK, "*On-Off Keying*".

**8.** Dispositif de réception selon l'une quelconque des revendications 1 à 6, **caractérisé en ce que** les signaux sont modulés suivant une modulation d'impulsions par position dans le temps à N positions, où N est un entier prédéterminé, N-PPM, "*N-Pulse Position Modulation*".

**9.** Dispositif de réception selon l'une quelconque des revendications 1 à 6, **caractérisé en ce qu'**il comporte un oscillateur composé d'un résonateur passif (40) du type LC dont la fréquence de résonance propre est réglé à la fréquence centrale desdits signaux d'excitation et, en parallèle, d'un élément actif (42) engendrant une résistance négative.

**10.** Moyen de communication, comportant des moyens d'oscillation répondant à une commande d'instabilité, ledit moyen de communication étant **caractérisé en ce qu'**il comporte en outre des moyens de commande d'adaptation d'un dispositif de réception selon l'une quelconque des revendications 1 à 9 au type de signaux à recevoir.

**11.** Dispositif de mise en état d'éveil d'un appareil radioélectrique, comportant des moyens d'oscillation répondant à une commande d'instabilité, ledit dispositif de mise en état d'éveil étant **caractérisé en ce qu'**il comporte en outre des moyens de commande d'adaptation d'un dispositif de réception selon l'une quelconque des revendications 1 à 9 au type de signaux à recevoir.

**12.** Dispositif de mise en état d'éveil d'un appareil radioélectrique, **caractérisé en ce qu'**il comporte un dispositif de réception selon l'une quelconque des revendications 1 à 9.

**13.** Dispositif de localisation d'un moyen de communication par un autre moyen de communication, lesdits moyens de communication comportant des moyens de mesure du temps, des moyens de conversion tension-temps et des moyens d'oscillation répondant à une commande d'instabilité, ledit dispositif de localisation étant **caractérisé en ce qu'**il comporte en outre des moyens de commande d'adaptation d'un dispositif de réception selon l'une quelconque des revendications 1 à 9 au type de signaux à recevoir.

**14.** Dispositif de localisation d'un moyen de communication par un autre moyen de communication, lesdits moyens de communication comportant des moyens de mesure du temps, des moyens de conversion tension-temps et des moyens d'oscillation répondant à une commande d'instabilité, ledit dispositif de localisation étant **caractérisé en ce qu'**il comporte un dispositif de réception selon l'une quelconque des revendications 1 à 9.

**15.** Dispositif de localisation selon la revendication 13 ou 14, **caractérisé en ce qu'**il comporte des moyens d'estimation de distance par calcul du temps de vol aller-retour.

**16.** Appareil d'émission/réception, comportant des moyens d'oscillation répondant à une commande d'instabilité, ledit appareil d'émission/réception étant **caractérisé en ce qu'**il comporte en outre des moyens de commande d'adaptation d'un dispositif de réception selon l'une quelconque des revendications 1 à 9 au type de signaux à recevoir.

**17.** Appareil d'émission/réception, **caractérisé en ce qu'**il comporte un dispositif de réception selon l'une quelconque des revendications 1 à 9.

**18.** Procédé de réception de signaux radiofréquence ULB, Ultra-Large Bande, impulsionnels, comportant une étape (122) d'amplification, une étape (124) d'oscillation conditionnée par une étape de commande d'instabilité, une étape (126) de mise en forme, une étape (128) de démodulation, ledit procédé étant **caractérisé en ce que** l'étape (124) d'oscillation est en outre effectuée en fonction d'une étape (125) de commande d'adaptation dudit procédé de réception au type de signaux à recevoir.

**19.** Procédé de réception selon la revendication 18, **caractérisé en ce que** l'étape (125) de commande d'adaptation dudit procédé au type de signaux à recevoir comporte une étape d'optimisation du contrôle de la commande d'instabilité.

**20.** Procédé de réception selon la revendication précédente, **caractérisé en ce que** l'étape (125) de commande d'adaptation met en oeuvre une forme prédéterminée de commande d'amortissement pour fournir une expression analytique du type de signaux reçus.

**21.** Procédé de réception selon la revendication 18, 19 ou 20, lesdits signaux étant reçus en provenance de trajets multiples, ledit procédé de réception étant **caractérisé en ce qu'**il comporte une étape de pondération de chacun desdits trajets.

**22.** Procédé de réception selon la revendication précédente, **caractérisé en ce qu'**il consiste en outre à appliquer à chacun desdits trajets un retard prédéterminé.

**23.** Procédé de réception selon les revendications 20 et 22, **caractérisé en ce que** la commande d'amortissement est différente pour chacun desdits trajets.

**24.** Procédé de réception selon l'une quelconque des revendications 18 à 23, **caractérisé en ce que** les signaux sont modulés suivant une modulation par tout ou rien, OOK, "*On-Off Keying*".

**25.** Procédé de réception selon l'une quelconque des revendications 18 à 23, **caractérisé en ce que** les signaux sont modulés suivant une modulation d'impulsions par position dans le temps à N positions, où N est un entier prédéterminé, N-PPM, "*N-Pulse Position Modulation*".

**26.** Procédé de mise en état d'éveil d'un appareil radioélectrique comportant une étape (124) d'oscillation conditionnée par une étape de commande d'instabilité, ledit procédé de mise en état d'éveil étant **caractérisé en ce qu'**il comporte en outre une étape de commande d'adaptation d'un procédé de réception selon l'une quelconque des revendications 18 à 25 au type de signaux à recevoir.

**27.** Procédé de mise en état d'éveil d'un appareil radioélectrique, **caractérisé en ce qu'**il comporte des étapes d'un procédé de réception selon l'une quelconque des revendications 18 à 25.

**28.** Procédé de localisation d'un moyen de communication par un autre moyen de communication, lesdits moyens de communication comportant des moyens de mesure du temps, des moyens de conversion tension-temps et des moyens d'oscillation répondant à une commande d'instabilité, ledit procédé de localisation étant **caractérisé en ce qu'**il comporte en outre une étape de commande d'adaptation d'un procédé de réception selon l'une quelconque des revendications 18 à 25 au type de signaux à recevoir.

**29.** Procédé de localisation d'un moyen de communication par un autre moyen de communication, lesdits moyens de communication comportant des moyens de mesure du temps, des moyens de conversion tension-temps et des moyens d'oscillation répondant à une commande d'instabilité, ledit procédé de localisation étant **caractérisé en ce qu'**il comporte des étapes d'un procédé de réception selon l'une quelconque des revendications 18 à 25.

**30.** Procédé de localisation selon la revendication 28 ou 29, **caractérisé en ce qu'**il comporte une étape d'estimation de distance par calcul du temps de vol aller-retour.

**31.** Procédé d'émission/réception comportant une étape (124) d'oscillation conditionnée par une étape de commande d'instabilité, ledit procédé d'émission/réception étant **caractérisé en ce qu'**il comporte en outre une étape de commande d'adaptation d'un procédé de réception selon l'une quelconque des revendications 18 à 25 au type de signaux à recevoir.

**32.** Procédé d'émission/réception, **caractérisé en ce qu'**il comporte des étapes d'un procédé de réception selon l'une quelconque des revendications 18 à 25.

**33.** Procédé de traitement de signaux, **caractérisé en ce qu'**il met en oeuvre des étapes d'un procédé de réception selon l'une quelconque des revendications 18 à 25.

**34.** Appareil de traitement de signaux, **caractérisé en ce qu'**il comporte un dispositif de réception selon l'une quelconque des revendications 1 à 9 et/ou un dispositif de localisation selon la revendication 13 ou 15.

**35.** Appareil nomade, **caractérisé en ce qu'**il comporte un dispositif de réception selon l'une quelconque des revendications 1 à 9 et/ou un dispositif de localisation selon la revendication 13 ou 15.

**36.** Téléphone mobile, **caractérisé en ce qu'**il comporte un dispositif de réception selon l'une quelconque des revendications 1 à 9 et/ou un dispositif de localisation selon la revendication 13 ou 15.

**37.** Appareil multimédia, **caractérisé en ce qu'**il comporte un dispositif de réception selon l'une quelconque des revendications 1 à 9 et/ou un dispositif de localisation selon la revendication 13 ou 15.

**Claims**

**1.** Device for receiving pulsed UWB (ultrawideband) radio-frequency signals, including amplification means (32; 82), oscillation means (34; 84) responsive to an instability control signal, shaping means (36; 86), demodulation means (38; 88), **characterised in that** it further includes control means (85) for adapting said oscillation means to the type of signals to be received.

**2.** Reception device according to claim 1, **characterised in that** the control means (85) for adapting said device to the type of signals to be received include means for optimisation of the control of the instability control signal of the oscillation means (34; 84).

**3.** Reception device according to the preceding claim, **characterised in that** said adaptation control means (85) use a predetermined form of damping control signal to supply an analytical expression of the type of signals received.

**4.** Reception device according to claim 1, 2 or 3, said signals being received from multiple paths, said reception device being **characterised in that** it includes means for weighting each of said paths.

**5.** Reception device according to the preceding claim, **characterised in that** it further includes delay means for applying to each of said paths a predetermined delay.

**6.** Reception device according to claims 3 and 5, **characterised in that** the damping control signal is different for each of said paths.

**7.** Reception device according to any one of the preceding claims, **characterised in that** the signals are modulated in accordance with an all or nothing form of modulation (OOK, On-Off Keying).

**8.** Reception device according to any one of claims 1 to 6, **characterised in that** the signals are modulated in accordance with N-pulse position modulation (N-PPM), where N is a predetermined integer.

**9.** Reception device according to any one of claims 1 to 6, **characterised in that** it comprises an oscillator composed of a passive resonator (40) of the LC type whose natural resonant frequency is adjusted to the central frequency of said excitation signals and, in parallel, of an active element (42) giving rise to a negative resistance.

**10.** Communication means, including oscillation means responsive to an instability control signal, said communication means being **characterised in that** they further include control means for adapting a reception device according to any one of claims 1 to 9 to the type of signals to be received.

**11.** Device for activating a radio device, including oscillation means responsive to an instability control signal, said activating device being **characterised in that** it further includes control means for adapting a reception device according to any one of claims 1 to 9 to the type of signals to be received.

**12.** Device for activating a radio device, **characterised in that** it includes a reception device according to any one of claims 1 to 9.

**13.** Device for location of communication means by other communication means, said communication means including time measuring means, voltage-time conversion means and oscillation means responsive to an instability control signal, said location device being **characterised in that** it further includes control means for adapting a reception device according to any one of claims 1 to 9 to the type of signals to be received.

14. Device for location of communication means by other communication means, said communication means including time measuring means, voltage-time conversion means and oscillation means responsive to an instability control signal, said location device being **characterised in that** it includes a reception device according to any one of claims 1 to 9.

15. Location device according to claim 13 or 14, **characterised in that** it includes means for estimation of distance by calculation of the round trip time.

16. Transmission/reception device, including oscillation means responsive to an instability control signal, said transmission/reception device being **characterised in that** it further includes control means for adapting a reception device according to any one of claims 1 to 9 to the type of signals to be received.

17. Transmission/reception device, **characterised in that** it includes a reception device according to any one of claims 1 to 9.

18. Method of reception of pulsed UWB (ultrawideband) radio-frequency signals, including an amplification step (122), a step (124) of oscillation conditioned by an instability control step, a shaping step (126), a demodulation step (128), said method being **characterised in that** the oscillation step (124) is additionally effected as a function of a control step (125) of adapting said reception method to the type of signals to be received.

19. Reception method according to claim 18, **characterised in that** the control step (125) of adapting said method to the type of signals to be received includes a step of optimisation of the control of the instability control signal.

20. Reception method according to the preceding claim, **characterised in that** the adaptation control step (125) uses a predetermined form of damping control signal to supply an analytical expression of the type of signals received.

21. Reception method according to claim 18, 19 or 20, said signals being received from multiple paths, said reception method being **characterised in that** it includes a step of weighting each of said paths.

22. Reception method according to the preceding claim, **characterised in that** it further consists in applying to each of said paths a predetermined delay.

23. Reception method according to claims 20 and 22, **characterised in that** the damping control signal is different for each of said paths.

24. Reception method according to any one of claims 18 to 23, **characterised in that** the signals are modulated in accordance with an all or nothing form of modulation (OOK, On-Off Keying).

25. Reception method according to any one of claims 18 to 23, **characterised in that** the signals are modulated in accordance with N-pulse position modulation (N-PPM), where N is a predetermined integer.

26. Method of activating a radio device, including a step (124) of oscillation conditioned by an instability control step, said activating method being **characterised in that** it further includes a control step of adapting a reception method according to any one of claims 18 to 25 to the type of signals to be received.

27. Method of activating a radio device, **characterised in that** it includes steps of a reception method according to any one of claims 18 to 25.

28. Method of location of communication means by other communication means, said communication means including time measuring means, voltage-time conversion means and oscillation means responsive to an instability control signal, said location method being **characterised in that** it further includes a control step of adapting a reception method according to any one of claims 18 to 25 to the type of signals to be received.

29. Method of location of communication means by other communication means, said communication means including time measuring means, voltage-time conversion means and oscillation means responsive to an instability control signal, said location method being **characterised in that** it includes steps of a reception method according to any one of claims 18 to 25.

30. Location method according to claim 28 or 29, **characterised in that** it includes a step of estimation of distance by calculation of the round trip time.

31. Transmission/reception method including a step (124) of oscillation conditioned by an instability control step, said transmission/reception method being **characterised in that** it further includes a control step of adapting a reception method according to any one of claims 18 to 25 to the type of signals to be received.

32. Transmission/reception method, **characterised in that** it includes steps of a reception method according to any one of claims 18 to 25.

33. Method of processing signals, **characterised in that** it executes steps of a reception method according to any one of claims 18 to 25.

34. Device for processing signals, **characterised in that** it includes a reception device according to any one of claims 1 to 9 and/or a location device according to claim 13 or 15.

35. Roaming device, **characterised in that** it includes a reception device according to any one of claims 1 to 9 and/or a location device according to claim 13 or 15.

36. Mobile telephone, **characterised in that** it includes a reception device according to any one of claims 1 to 9 and/or a location device according to claim 13 or 15.

37. Multimedia device, **characterised in that** it includes a reception device according to any one of claims 1 to 9 and/or a location device according to claim 13 or 15.

**Patentansprüche**

1. Vorrichtung zum Empfang von UBB, UltraBreitBand-Funkfrequenzimpulssignalen, umfassend Verstärkungsmittel (32; 82), Oszillationsmittel (34; 84), die auf eine Instabilitätssteuerung antworten, Formungsmittel (36; 86), Demodulationsmittel (38; 88), **dadurch gekennzeichnet, dass** sie außerdem Mittel (85) zur Steuerung der Anpassung der Oszillationsmittel an den Typ von zu empfangenden Signalen umfasst.

2. Empfangsvorrichtung nach Anspruch 1, **dadurch gekennzeichnet, dass** die Mittel (85) zur Steuerung der Anpassung der Vorrichtung an den Typ von zu empfangenden Signalen Mittel zur Optimierung der Kontrolle der Instabilitätssteuerung der Oszillationsmittel (34; 84) umfassen.

3. Empfangsvorrichtung nach dem vorhergehenden Anspruch, **dadurch gekennzeichnet, dass** die Mittel (85) zur Anpassungssteuerung eine vorbestimmte Form der Dämpfungssteuerung benutzen, um einen analytischen Ausdruck des Typs von empfangenen Signalen zu liefern.

4. Empfangsvorrichtung nach Anspruch 1, 2 oder 3, wobei die Signale von mehreren Wegen kommend empfangen werden, wobei die Empfangsvorrichtung **dadurch gekennzeichnet ist, dass** sie Mittel zur Gewichtung jedes dieser Wege umfasst.

5. Empfangsvorrichtung nach dem vorhergehenden Anspruch, **dadurch gekennzeichnet, dass** sie außerdem Verzögerungsmittel umfasst, um an jeden dieser Wege eine vorbestimmte Verzögerung anzulegen.

6. Empfangsvorrichtung nach den Ansprüchen 3 und 5, **dadurch gekennzeichnet, dass** die Dämpfungssteuerung für jeden der Wege verschieden ist.

7. Empfangsvorrichtung nach einem der vorhergehenden Ansprüche, **dadurch gekennzeichnet, dass** die Signale gemäß einer Ein-Aus-Modulation, OOK, "*On-Off Keying*", moduliert werden.

8. Empfangsvorrichtung nach einem der Ansprüche 1 bis 6, **dadurch gekennzeichnet, dass** die Signale gemäß einer Modulation von Impulsen nach der Stellung in der Zeit mit N Stellungen moduliert werden, worin N eine vorbestimmte ganze Zahl ist, N-PPM, "*N-Pulse Position Modulation*".

9. Empfangsvorrichtung nach einem der Ansprüche 1 bis 6, **dadurch gekennzeichnet, dass** sie einen Oszillator umfasst, der aus einem passiven LC-Resonator (40), dessen Eigenresonanzfrequenz auf die Mittelfrequenz der Erregungssignale eingestellt wird, und parallel aus einem aktiven Element (42) besteht, das einen negativen Widerstand erzeugt.

10. Kommunikationsmittel, umfassend Oszillationsmittel, die auf eine Instabilitätssteuerung antworten, wobei das Kommunikationsmittel **dadurch gekennzeichnet ist, dass** es außerdem Mittel zur Steuerung der Anpassung einer Empfangsvorrichtung nach einem der Ansprüche 1 bis 9 an den Typ von zu empfangenden Signalen umfasst.

11. Vorrichtung zur Überführung eines Funkgeräts, das auf eine Instabilitätssteuerung antwortende Oszillationsmittel umfasst, in den Wachzustand, wobei die Vorrichtung zur Überführung in den Wachzustand **dadurch gekennzeichnet ist, dass** sie außerdem Mittel zur Steuerung der Anpassung einer Empfangsvorrichtung nach einem der Ansprüche 1 bis 9 an den Typ von zu empfangenden Signalen umfasst.

12. Vorrichtung zur Überführung eines Funkgeräts in den Wachzustand, **dadurch gekennzeichnet, dass** sie eine Empfangsvorrichtung nach einem der Ansprüche 1 bis 9 umfasst.

13. Vorrichtung zur Ortung eines Kommunikationsmittels durch ein anderes Kommunikationsmittel, wobei die Kommunikationsmittel Mittel zur Messung der Zeit, Mittel zur Spannungs-Zeit-Umwandlung und auf eine Instabilitätssteuerung antwortende Oszillationsmittel umfassen, wobei die Ortungsvorrichtung **dadurch gekennzeichnet ist, dass** sie außerdem Mittel zur Steuerung der Anpassung einer Empfangsvorrichtung nach einem der Ansprüche 1 bis 9 an den Typ von zu empfangenden Signalen umfasst.

14. Vorrichtung zur Ortung eines Kommunikationsmittels durch ein anderes Kommunikationsmittel, wobei die Kommunikationsmittel Mittel zur Messung der Zeit, Mittel zur Spannungs-Zeit-Umwandlung und auf eine Instabilitätssteuerung antwortende Oszillationsmittel umfassen, wobei die Ortungsvorrichtung **dadurch gekennzeichnet ist, dass** sie eine Empfangsvorrichtung nach einem der Ansprüche 1 bis 9 umfasst.

15. Ortungsvorrichtung nach Anspruch 13 oder 14, **dadurch gekennzeichnet, dass** sie Mittel zum Schätzen der Entfernung durch Berechnung der Hin- und Rückflugzeit umfasst.

16. Sende/Empfangsgerät, umfassend Oszillationsmittel, die auf eine Instabilitätssteuerung antworten, wobei das Sende/Empfangsgerät **dadurch gekennzeichnet ist, dass** es außerdem Mittel zur Steuerung der Anpassung einer Empfangsvorrichtung nach einem der Ansprüche 1 bis 9 an den Typ von zu empfangenden Signalen umfasst.

17. Sende/Empfangsgerät, **dadurch gekennzeichnet, dass** es eine Empfangsvorrichtung nach einem der Ansprüche 1 bis 9 umfasst.

18. Verfahren zum Empfang von UBB, Ultra-BreitBand-Funkfrequenz-Impulssignalen, umfassend einen Verstärkungsschritt (122), einen Schritt (124) der durch einen Instabilitätssteuerungsschritt bedingten Oszillation, einen Formungsschritt (126), einen Demodulationsschritt (128), wobei das Verfahren **dadurch gekennzeichnet ist, dass** der Oszillationsschritt (124) außerdem in Abhängigkeit von einem Schritt (125) der Steuerung der Anpassung des Empfangsverfahrens an den Typ von zu empfangenden Signalen durchgeführt wird.

19. Empfangsverfahren nach Anspruch 18, **dadurch gekennzeichnet, dass** der Schritt (125) der Steuerung der Anpassung des Verfahrens an den Typ von zu empfangenden Signalen einen Schritt der Optimierung der Kontrolle der Instabilitätssteuerung umfasst.

20. Empfangsverfahren nach dem vorhergehenden Anspruch, **dadurch gekennzeichnet, dass** der Schritt (125) der Anpassungssteuerung eine vorbestimmte Form der Dämpfungssteuerung benutzt, um einen analytischen Ausdruck des Typs von empfangenen Signalen zu liefern.

21. Empfangsverfahren nach Anspruch 18, 19 oder 20, wobei die Signale von mehreren Wegen kommend empfangen werden, wobei das Empfangsverfahren **dadurch gekennzeichnet ist, dass** es einen Schritt der Gewichtung jedes der Wege umfasst.

22. Empfangsverfahren nach dem vorhergehenden Anspruch, **dadurch gekennzeichnet, dass** es außerdem darin besteht, dass an jeden der Wege eine vorbestimmte Verzögerung angelegt wird.

23. Empfangsverfahren nach den Ansprüchen 20 und 22, **dadurch gekennzeichnet, dass** die Dämpfungssteuerung für jeden der Wege verschieden ist.

24. Empfangsverfahren nach einem der Ansprüche 18 bis 23, **dadurch gekennzeichnet, dass** die Signale gemäß einer Ein-Aus-Modulation, OOK, "*On-Off Keying*", moduliert werden.

25. Empfangsverfahren nach einem der Ansprüche 18 bis 23, **dadurch gekennzeichnet, dass** die Signale gemäß einer Impulsmodulation nach Stellung in der Zeit mit N Stellungen moduliert werden, worin N eine vorbestimmte ganze Zahl ist, N-PPM, "*N-Pulse Position Modulation*".

26. Verfahren zum Überführen eines Funkgeräts in den Wachzustand, umfassend einen Schritt (124) der durch einen Instabilitätssteuerungsschritt bedingten Oszillation, wobei das Verfahren zur Überführung in den Wachzustand **dadurch gekennzeichnet ist, dass** es außerdem einen Schritt der Steuerung der Anpassung eines Empfangsverfahrens nach einem der Ansprüche 18 bis 25 an den Typ von zu empfangenden Signalen umfasst.

27. Verfahren zur Überführung eines Funkgeräts in den Wachzustand, **dadurch gekennzeichnet, dass** es Schritte eines Empfangsverfahrens nach einem der Ansprüche 18 bis 25 umfasst.

28. Verfahren zur Ortung eines Kommunikationsmittels durch ein anderes Kommunikationsmittel, wobei die Kommunikationsmittel Mittel zum Messen der Zeit, Mittel zur Spannungs-Zeit-Umwandlung und auf eine Instabilitätssteuerung antwortende Oszillationsmittel umfassen, wobei das Ortungsverfahren **dadurch gekennzeichnet ist, dass** es außerdem einen Schritt der Steuerung der Anpassung eines Empfangsverfahrens nach einem der Ansprüche 18 bis 25 an den Typ von zu empfangenden Signalen umfasst.

29. Verfahren zur Ortung eines Kommunikationsmittels durch ein anderes Kommunikationsmittel, wobei die Kommunikationsmittel Mittel zum Messen der Zeit, Mittel zur Spannungs-Zeit-Umwandlung und auf eine Instabilitätssteuerung antwortende Oszillationsmittel umfassen, wobei das Ortungsverfahren **dadurch gekennzeichnet ist, dass** es Schritte eines Empfangsverfahrens nach einem der Ansprüche 18 bis 25 umfasst.

30. Ortungsverfahren nach Anspruch 28 oder 29, **dadurch gekennzeichnet, dass** es einen Schritt der Schätzung der Entfernung durch Berechnung der Hin- und Rückflugzeit umfasst.

31. Sende/Empfangsverfahren, umfassend einen Schritt (124) der durch einen Instabilitätssteuerungsschritt bedingten Oszillation, wobei das Sende/Empfangsverfahren **dadurch gekennzeichnet ist, dass** es außerdem einen Schritt der Steuerung der Anpassung eines Empfangsverfahrens nach einem der Ansprüche 18 bis 25 an den Typ von zu empfangenden Signalen umfasst.

32. Sende/Empfangsverfahren, **dadurch gekennzeichnet, dass** es Schritte eines Empfangsverfahrens nach einem der Ansprüche 18 bis 25 umfasst.

33. Verfahren zur Verarbeitung von Signalen, **dadurch gekennzeichnet, dass** es Schritte eines Empfangsverfahrens nach einem der Ansprüche 18 bis 25 benutzt.

34. Gerät zur Verarbeitung von Signalen, **dadurch gekennzeichnet, dass** es eine Empfangsvorrichtung nach einem der Ansprüche 1 bis 9 und/oder eine Ortungsvorrichtung nach Anspruch 13 oder 15 umfasst.

35. Nomadisches Gerät, **dadurch gekennzeichnet, dass** es eine Empfangsvorrichtung nach einem der Ansprüche 1 bis 9 und/oder eine Ortungsvorrichtung nach Anspruch 13 oder 15 umfasst.

36. Mobiltelefon, **dadurch gekennzeichnet, dass** es eine Empfangsvorrichtung nach einem der Ansprüche 1 bis 9 und/oder eine Ortungsvorrichtung nach Anspruch 13 oder 15 umfasst.

37. Multimediagerät, **dadurch gekennzeichnet, dass** es eine Empfangsvorrichtung nach einem der Ansprüche 1 bis 9 und/oder eine Ortungsvorrichtung nach Anspruch 13 oder 15 umfasst.

## FIG. 1A

v(t) (mvolts)

temps t (ns)

## FIG. 1B

DSP (dBm/MHz)

--- Masque FCC

fréquence (GHz)

PRI          PRI

INFORMATION BINAIRE

1

0

Temps

MODULATION OOK

0

Temps

MODULATION 2PPM

IPI      IPI      IPI      IPI

0

Temps

## FIG. 2

commande de contrôle
des oscillations

30

32

34

36

38

AMPLI    OSC    MISE EN
FORME    DEMODULATION

## FIG. 3

OSC

40

R

42    -R

commande de
contrôle des oscillations

## FIG. 4

Pente : Contrôle de la bande passante du récepteur
Aire : Contrôle du gain du super-régénérateur
Pente : Contrôle de la forme du signal de sortie
Aire : Contrôle la rapidité de l'amortissement

FIG. 5

MISE EN FORME

60

FIG. 6

DEMODULATION OOK

réf OOK

70

**FIG. 7A**

DEMODULATION PPM

70

Δ

72

**FIG. 7B**

commande de
contrôle des
oscillations

ORGANE DE
PROGRAMMATION

85

$850_1$

$850_2$

$850_N$

D1

D2

DN

80

82

AMPLI

OSC

84

86

MISE EN
FORME

88

DEMODULATION

**FIG. 8**

FIG. 9

FIG. 10

EMISSION
NOEUD A

RECEPTION
NOEUD A

NOEUD A

0

temps

RECEPTION
NOEUD B

RE-EMISSION
NOEUD B

NOEUD B

0

temps

T calcul

HORLOGE
NOEUD A

0

numérisation
du niveau

temps

T AR

## FIG. 11

Amplification ⟋ 122

Commande
adaptation
au type de signaux
à détecter

Oscillation ⟋ 124

Mise en forme ⟋ 126

Démodulation ⟋ 128

125

## FIG. 12

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

**Documents brevets cités dans la description**

- WO 0176086 A
- US 5901172 A
- US 3329952 A
- WO 03009482 A
- US 4749964 A

**Littérature non-brevet citée dans la description**

- **E. H. AMSTRONG.** Some recent developments of regenerative circuits. *Proc. IRE,* Août 1922, vol. 10, 244-260
- **J.R. WHITEHEAD.** Super-Regenerative Receivers. Cambridge University Press, 1950